# EUROPEAN PATENT APPLICATION

(11) **EP 1 400 293 A2**
(43) Date of publication of application: **24.03.2004**
(21) Application number: 03014921.5
(22) Date of filing: 01.07.2003
(51) Int. Cl.: B23B 27/14, C04B 41/45, C04B 41/50

(54) **PVD coated cutting tool**

(30) Priority: 16.07.2002 SE 0202230
(71) Applicant: SECO TOOLS AB, 732 82 Fagersta (SE)
(72) Inventor: SJölen Jacob, S 73741 Fagersta (SV); Frisk Lars, S 73731 Fagersta (SV)
(74) Representative: Taquist, Lennart

(57) **Abstract**

The present invention relates to a cutting tool consisting of a substrate and a coating containing at least one layer having an X-ray diffraction pattern. Said pattern shows the presence of a crystalline structure as well as of an amorphous structure. Preferably said layer consists of (Ti,Al)(O,N). The tool is particularly useful for machining steel, hardened steel or stainless steel, preferably milling of stainless steel.

## Description

The present invention relates to a cutting tool for machining by chip removal comprising a substrate of cemented carbide, cermet, ceramics, cubic boron nitride or high-speed steel and a hard and wear resistant refractory coating. The coating is composed of one or more layers of refractory compounds of which at least one layer comprises a dense layer containing a mixture of an amorphous and a crystalline phase in particular a (Ti,Al) (O,N)-layer.

### Background of the invention:

US 4,474,849 discloses a coated hard alloys excellent in toughness and wear resistance comprise a substrate of hard alloy and at least one layer thereon, at least one of the layers being of amorphous alumina.

US 5,330,853 discloses a coated surface with alternating first and second ternary layers, wherein the first layer TiAlNₓ has a higher nitrogen content and is considerably thinner than the second layer TiAlN_{y}. The layers are deposited using sputtering of a TiAl target.

US 5,549,975 discloses a coated tool consisting of a cermet body, coated with a wear resistant layer of (Ti, Me) N, wherein Me is at least one metal which forms a stable oxide at a temperature above 700 °C. The deposition process is a combination of evaporation and sputtering.

US 5,503,912 disclose a coating formed of ultra-thin layers comprising at least one nitride or carbonitride of at least one element selected from the group consisting of the elements in the groups IVa, Va and VIa in the periodic table and A1 and B. The overall compound having a cubic crystalline X-ray diffraction pattern, in spite of that one of the layers having a crystal structure other than the cubic crystal structure at normal temperature and normal pressure and under equilibrium state. This coating is in practice a laminate of TiN and AlN were each layer has a thickness of 0.2-50 nm.

US 5,879,823 discloses coated cutting tool with an innermost layer of a Group IVB metal-aluminium alloy, and a second layer of alumina applied by physical vapour deposition. US 6,254,984 disclose a multi-layer-coated consisting of a first layers each composed of at least one of carbides, nitrides and carbonitrides of elements of Groups 4a, 5a and 6a of the Periodic Table and A1, and two or more second layers each composed of at least one of oxides, carboxides, oxinitrides and carboxinitrides of elements of Groups 4a, 5a and 6a of the Periodic Table and A1 laminated alternately. The first layers adjacent via the second layer are continuous in crystal orientation. In the description is also an outer amorphous layer deposited in order to increase the oxidation resistance

US 6,071,560 discloses a wear resistant coating containing at least one layer of MeX, where Me comprises titanium and aluminium and X is nitrogen or carbon. In the MeX layer, the texture measured with X-ray diffraction is preferably (200).

R. Luthier and F. Levy, J. Vac. Sci. Technol., A9 (1) (1991) 102 have grown TiAlON layers by rf magnetron sputtering from a ceramic target consisting of TiN-Al₂O₃. They obtained a mixed structure consisting of (Ti,Al)Nₓ and amorphous (Ti,Al)O₂. The obtained XRD patterns from those layers consist of peaks originating from crystalline phase together with an amorphous hump.

K. Kawata, H. Sugimura, and O. Takai, Thin Solid Films 390 (2001) 64 have grown different Ti-Al-O-C-N layers using plasma-enhanced chemical vapour deposition (PACVD).

Several authors have reported formation of crystalline or amorphous layers on top of (Ti,Al)N spontaneously formed during a post-oxidation step or usage at elevated temperature, see e.g. Munz et al, J. Vac. Sci. Technol. 4 (6) (1986)2717-2727.

### Objects and summary of the invention

It is an object of this invention to improve several properties known from prior art, such as oxidation resistance, surface roughness, layer toughness and wear resistance.

It has now been found that a coated cutting tool provided with a coating that consists of one or several layers, of which one or at least one layer has a crystalline structure combined with an amorphous structure, has an improved wear resistance and toughness compared to prior art coatings.

Fig 1 shows an X-ray diffraction pattern from a layer according to the invention where
A - SPVII fitted curves [1,2]
H - height of the amorphous peak
P - height of the highest crystalline peak of the coating
B - background level

Fig 2 shows a SEM-micrograph of a fracture cross section from a sample according to the invention.

Fig 3 shows θ-2θ X-ray diffraction scans 20° < 2θ<90° from layers with different oxygen contents.

The present invention thus relates to a cutting tool consisting of a coating and a substrate. The substrate consists of cemented carbide, cermet, high-speed steel or cubic boron nitride. The coating is composed of one or several layers of which at least one layer consists of a crystalline structure combined with an amorphous structure. Said layer has a thickness of 0.3-20 µm, preferably 0.3-10 µm. The total coating thickness is 0.5 - 20 µm.

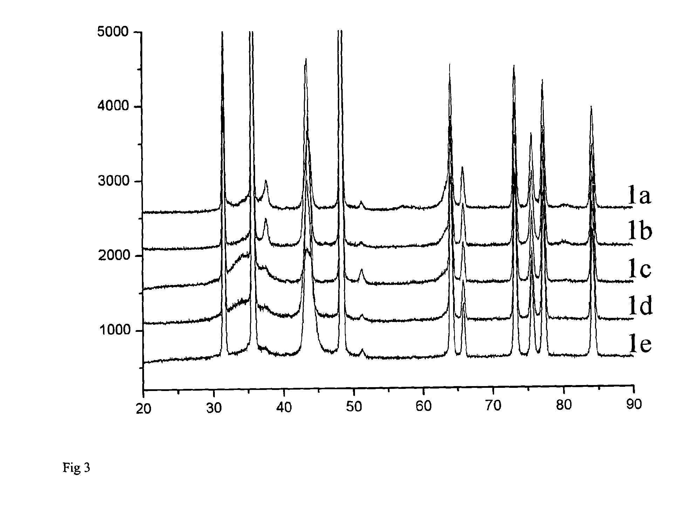

The structure of the layer is quantified with respect to the background level, B, the height of the amorphous peak, H, and the height of the highest peak from the crystalline structure, using Cu K α -radiation (λ = 1.54 Å), see figure 3. A SPVII-curve fitting algorithm [1,2] is used to extract data for both the amorphous peak and the crystalline peak.

The Chebychev background radiation[1,2], B, is calculated between 20° < 2 θ < 60°.

According to the invention H>3B and P>5B and 0.75<P/H<3.

Preferably said layer is a (Ti,Al) (N,O)-layer having a crystalline (Ti,Al)N-osbornite (NaCl) structure in combination with an amorphous structure.

The amorphous structure is identified by a broad peak between 20 ° < 2 θ < 48° with 4° < FWHM < 7°. The amorphous structure results in Bragg reflections at 30° < 2θ < 40° preferably 32° < 2θ < 38° which corresponds to atomic distances between 1.9 Å - 4.4 Å with a maximum, H, centred at an atomic distance of 2.5 Å.

The crystalline NaCl-structure of (Ti,Al)N is identified by the reflections from the (111)-, (200)- and (220)-planes, corresponding to positions 2θ = 37.5°, 43.5° and 63.5° respectively, in a θ - 2θ scan using Cu-Kα radiation.

The layer according to the present invention can be deposited directly on to the substrate or on one or more interlayers as known in the art. Likewise can further layers be deposited on top of said layer.

The (Ti,Al) (O,N)-layer when it is a single layer is also characterised by a smooth surface with a small amount of droplets of small size, surface roughness Rₐ<0.2 µm measured over a length of 2.5 mm with a stylus method.

The composition of the (TiₓAl₁₋ₓ) (O_{y},N_{1-y}) layer is 0.20<x<0.70 and 0.15<y<0.35, preferably 0.25<x<0.55 and 0.20<y<0.30 using a quantitative EDX measurement method with ZAF correction at 10 kV and 25 mm working distance.

The layer is deposited by arc-evaporation of metallic TiAl-targets, with a R_{Me} = Ti%at/(Ti%at + Al%at)-ratio, 0.20 < R_{Me} < 0.70, using an evaporator current, I_{EVAP}, set to 6 x 100 A in a reactive atmosphere consisting of N₂, O₂ and Ar, with a ratio R_{Gas} = O₂/( ( N₂ + O₂) , 0.05 < R < 0.15 and a total pressure, P, set to 1.0 < P < 10 Pa during deposition. The applied bias voltage, U_{BIAS}, is - 30 < U_{BIAS} < -600 V.

The exact process parameters are dependent on the design of the coating equipment used. It is within the purview of the skilled artisan to determine whether the requisite structure has been obtained and to modify the deposition conditions in accordance with the present specification.

The coated cutting tool according to the invention is particularly useful for machining steel, hardened steel or stainless steel, preferably milling of stainless steel.

### Example 1

(Ti,Al) (O,N)-layers were deposited in a commercially available arc evaporation deposition system aimed for thin film deposition.

Mirror-polished cemented carbide substrates with composition 6 wt% Co and 94 wt% WC were used for analysis. Inserts used for cuttings tests were coated in the same batches.

Before deposition, the substrates were cleaned in ultrasonic baths of an alkali solution, in deionized water and in alcohol. The substrates were mounted on a rotating fixture. The minimum distance between cathodes and substrates was approximately 100 mm.

The substrates were heated by infrared heaters for 20 minutes prior to the actual coating process.

The subsequent (Ti,Al) (O,N)-deposition was carried out at varying gas-mixtures R_{Gas} = O₂/(N₂ + O₂), R_{Gas} = 0, 0.026, 0.079, 0.18 and 0.24. The evaporator current was set to 6 x 100A, the substrate bias was -120 V and the total pressure was 2.0 Pa. The temperature during the coating process was 520°C, measured with two infrared pyrometers.

The resulting thickness of the coatings was 4.0µm.

The substrate current density was 1.2 mA/cm².

XRD analysis showed that all films exhibited the cubic osbornite structure. For the layers with low levels of oxygen in the coating process, a broad peak from an amorphous structure was also found. The amorphous structure was most prominent for the ratios φO₂/(φN₂ + φO₂) = 0.079, and 0.18, corresponding to a measured oxygen content in the layer of 10 %at, and 22%at respectively, using an EDX measurement method.

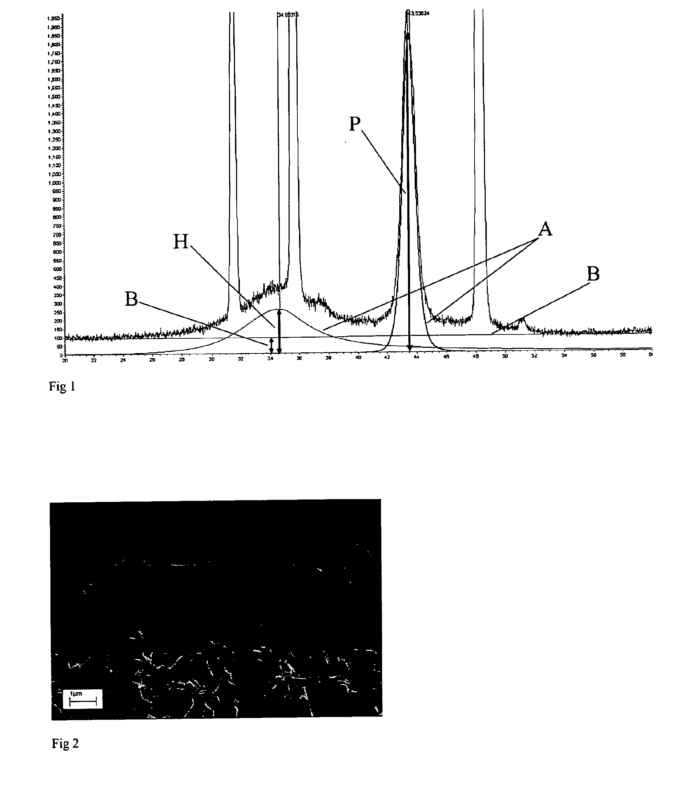

SEM studies of fracture cross-sections revealed columnar structure for layers deposited with low oxygen levels, φO₂/(φN₂ + φO₂) = 0 and 0.026, resulting in oxygen levels in the coating of 2%at and 10%at respectively. The structure vanished as the oxygen level increased Fig 2. The intensities of the amorphous peaks H/B are listed in table below.

The hardness and Young's modulus was measured by nanoindentation. The results are listed in the table below. The hardness and Young's modulus decreases with increasing levels of oxygen in the layer, hence the toughness is improved by adding oxygen in the process.

The adhesion and toughness were measured using a reve test. A diamond stylus was used with loads ranging from 10 - 100 N. All layers showed a very good adhesion (> 60 N), layers with high levels of oxygen were less brittle than layers with low amounts of oxygen. The reve test demonstrate that layers according to present invention have strongly enhanced toughness properties compared to layers grown without oxygen.

The surface roughness, Ra, was measured with a stylus profilometer, using a Perthometer instrument. The surface roughness of the uncoated substrates was Ra < 5 nm measured with AFM (Atomic Force Microscope), which doesn't influence the result of the roughness parameters of the layers. It is obvious that the surface roughness decreases when increasing the oxygen content, see table 1. The significant difference in surface roughness is Found when layers with and without oxygen are compared.

Table 1. Oxygen levels and properties of the (Ti,Al) (O,N) Layers.

| Label | φO₂/ (φN₂+φO₂) | H [GPa] | E [GPa] | Ra [µm] | H/B | P/B | Structure |
|---|---|---|---|---|---|---|---|
| 1a | 0 | 34.7 | 600 | 0.26 | 1.9 | 12.1 | Columnar |
| 1b | 0.026 | 28.8 | 420 | 0.16 | 1.5 | 29.9 | Columnar |
| 1c | 0.079 | 31.1 | 440 | 0.15 | 5.8 | 6.5 | Fine grained <0.1 µm |
| 1d | 0.18 | N/A | N/A | 0.12 | 4.7 | 20.2 | Fine grained <0.1 µm |
| 1e | 0.24 | N/A | N/A | 0.09 | 2.9 | 38.2 | Fine grained <0.1 µm |

### Example 2

Inserts of the same type as the ones used in Example 1 were coated with a binary layer composed of a (Ti,Al)N-layer with columnar structure followed by a layer of mixed amorphous and crystalline structure composed of (Ti,Al)(O,N).

The pretreatment of the inserts before coating was performed in the same way as in Example 1. The coating process was carried out in N₂-atmosphere at 2.0 Pa, while TiAl was evaporated from six cathodes. The substrates were biased at -120 V and the evaporator current was set to 6 x 100A. The deposition temperature was 520°C. The thickness of this layer was 2.0 µm.

The second layer of the coating was identical to 1c of Example 1.

The total thickness of the coating was 4.0 µm.

It is possible to distinguish the bilayered coating from a single layer by gracing incidence XRD-scan. It is within the purview of the skilled artisan to set up the parameters for such an analysis.

This coating is herein referred to as 2a.

### Example 3

A cemented carbide cutting tool insert with the composition 6%wt Co, 0.5%wt TaC and 93.5%wt WC with different coatings were used in a turning operation in steel (SS1672, AISI-1042, DIN-Ck 45) .

### Coatings:

The coatings described in example 1, example 2 and two types of coatings known from prior art, i.e. TiN and (Ti,Al)N coatings, were compared.
Cutting data
Insert geometry SNUN120408
Cutting speed 250 m/min
Cutting depth 1.5 mm
Cutting feed 0.35 mm
Results (Tool life)

| | | |
|---|---|---|
| 1a | 20 minutes | outside invention |
| 1b | 28 minutes | outside invention |
| 1c | 32 minutes | invention |
| 1d | 16 minutes | outside invention |
| 1e | 10 minutes | outside invention |
| 2a | 22 minutes | invention |
| TiN | 12 minutes | prior art |
| (Ti,Al)N | 18 minutes | prior art |

### Example 4

A cemented carbide cutting insert with the composition 13%wt Co and 87%wt WC with different coatings, described in example 1 and example 2, were used in a square shoulder milling operation in stainless steel (SS2343, AISI-316, DIN-X5 CrNiMo 17 13 3).
Cutting data
Insert geometry XOMX090308TR-ME06
Cutting speed 260 m/min
Cutting depth 3.0 mm
Cutting feed 0.23 mm
Cutting width 5 mm

Tool life criterion was destruction of the cutting edge due to chipping, which was caused by built up edge. The test result shows that the insert with the bi-layered coating, described in example 2, showed longer tool life compared to the same substrate coated with other coatings.

### Results (Tool life) in minutes

| | | |
|---|---|---|
| 1a | 14 | outside invention |
| 1b | 12 | outside invention |
| 1c | 12 | invention |
| 1d | 8 | outside invention |
| 1e | 6 | outside invention |
| 2a | 16 | invention |
| TiN | 8 | prior art |
| (Ti,Al)N | 14 | prior art |

### Example 5

A solid carbide drill with the composition 10%wt Co and 90%wt WC with different coatings, described in example 1 and example 2, were used in a bottomless hole drilling operation in steel (SS1672, AISI-1042, DIN-Ck 45).
Cutting data
Drill type SD25-6,0-32-6R5
Cutting speed 80 m/min
Cutting depth 24 mm
Cutting feed 0.16 mm

### Results (Tool life) in number of holes

| | | |
|---|---|---|
| 1a | 1000 | outside invention |
| 1b | 1200 | outside invention |
| 1c | 1600 | invention |
| 1d | 600 | outside invention |
| 1e | 200 | outside invention |
| 2a | 1000 | invention |

### References

- [1]: Bruker AXS (2000)
Topas V2.0: General profile and structure analysis software for powder diffraction data.
-User Manual, Bruker AXS, Karlsruhe, Germany
- [2]: Cheary, R.W., Coelho, A.A. (1992)
A fundamental parameters approach to X-ray line profile fitting
-J. Appl. Cryst., 25, 109-121

## Claims

1. A cutting tool insert consisting of a substrate and a coating containing at least one layer having an X-ray diffraction pattern **characterized in that** said pattern shows the presence of a crystalline structure with narrow peaks with highest peak with height P as well as of an amorphous structure with a broad peak with height H, with H>3B and P>5B and 0.75<P/H<3, where B is the Chebychev background radiation, and with a total thickness of this layer of 0.3 µm - 20 µm.

2. A cutting tool insert according to claim 1 **characterized in that** said crystalline structure is cubic, preferably osbornite structure.

3. A cutting tool insert according to claim 1, or 2 **characterized in that** said layer consists of (Ti,Al) (O,N).

4. A cutting tool insert according to claim 3 **characterized in that** said (Ti,Al) (O,N)-layer has a composition such that the (TiₓAl₁₋ₓ) (O_{y},N_{1-y}) layer is 0.20<x<0.70 and 0.15<y<0.35.

5. A cutting tool insert according to any of the previous claims **characterized in that** said layer is the outermost layer of the coating.

6. A cutting tool insert according to any of the previous claims **characterized in that** said substrate is cemented carbide, cermet, ceramics or cubic boron nitride.

7. A method for producing a coated cutting tool for metal machining, wherein at least one layer consists of (Ti,Al)(O,N), **characterised in that** the (Ti,Al) (O,N) -layer is deposited by arc-evaporation of TiAl-targets, with a RMe = Ti%at/(Ti%at + Al%at)-ratio between 0.20 and < 0.70 using a negative substrate bias between 20 and 150 V, in a reactive atmosphere consisting of N₂, O₂ and Ar at a total pressure, P, set to 1.0 < P < 10 Pa, with a ratio R = O₂/( N₂ + O₂), 0.05 < R < 0.15.
